**Europäisches Patentamt**

**European Patent Office**

**Office européen des brevets**

(19)

(11) Publication number : **0 361 233 B1**

(12)

# EUROPEAN PATENT SPECIFICATION

(45) Date of publication of patent specification :
23.11.94 Bulletin 94/47

(51) Int. Cl.⁵ : **G11C 11/407, H03K 5/153, H03K 19/003**

(21) Application number : **89117106.8**

(22) Date of filing : **15.09.89**

(54) Glitch suppression circuit.

(30) Priority : **16.09.88 US 245197**

(43) Date of publication of application :
**04.04.90 Bulletin 90/14**

(45) Publication of the grant of the patent :
**23.11.94 Bulletin 94/47**

(84) Designated Contracting States :
**DE FR GB IT NL**

(56) References cited :
**EP-A- 0 105 757**
**US-A- 4 337 525**
**J. MILLMAN & A. GRAVI-**
**N:"Microelectronics", 2nd edition, 1988,**
**McGraw-Hill Book Co., SG**

(73) Proprietor : **TEXAS INSTRUMENTS INCORPORATED**
**13500 North Central Expressway**
**Dallas Texas 75265 (US)**

(72) Inventor : **Childers, Jimmie D.**
**16707 Quail Briar**
**Missouri City Texas 77489 (US)**
Inventor : **Norwood, Roger D.**
**2214 Canebreak**
**Sugarland Texas 77478 (US)**

(74) Representative : **Leiser, Gottfried, Dipl.-Ing. et al**
**Prinz & Partner,**
**Manzingerweg 7**
**D-81241 München (DE)**

EP 0 361 233 B1

## Description

### FIELD OF THE INVENTION

The present invention relates to the field of digital circuitry. More specifically, the present invention relates the field of error suppression in digital circuitry.

### BACKGROUND OF THE INVENTION

Digital techniques have become the circuit techniques of choice in electronic design. The high noise immunity of digital circuitry provides more reliability than analog circuitry. This stems from the binary nature of digital signals. Minor noise or component variations do not affect the information carried on a digital signal so long as they do not change a binary bit from a logical 1 to a logical 0 or vice versa. This provides a high degree of data integrity in digital circuitry.

On the other hand, problems which do cause the value of a binary bit to change (glitches) can cause errors which propagate throughout the circuit. A change in one bit in a digital number can drastically change the value of that number. Thus, although digital circuitry is more immune to error than analog circuitry, the errors that do occur can have more impact. Therefore it is very important to eliminate or mitigate all potential sources of glitches.

One common source of glitches is timing errors. Timing errors occur when signals arrive at the input terminals of a combinatorial circuit, such as a logic gate, at different times. The combinatorial circuit reacts to the combination of the old signal value of the slow signal with the new signal value of the fast signal. The combinatorial circuit then provides an output signal in response to the old and new signals when it should only provide an output signal in response to the two old signals and then the two new signals.

Most digital signals do not arrive at a combinatorial circuit at exactly the same time, but, in most circumstances this is not a problem. Either the combinatorial circuit does not react quickly enough to produce a glitch output signal before the correct new signal is received or appropriate timing design assures that these glitches are lost in the system. However, in some asynchronous designs and capacitive discharge circuits, this type of glitch can cause errors or seriously impair proper operation of the circuit. Therefore it is important to eliminate these glitches in those types of circuits which are sensitive to them.

From U.S.-A-4,337,525 a circuit for performing a combinatorial operation in response to at least two logical input signals is known. In this circuit means are provided which disable all circuit portions which could either create or would be sensitive to a glitch so that the circuit is not functional during the relevant time period. The time period in which circuit portions are disabled results in a delay which has an adverse effect on the operation speed of the circuit.

This document discloses the features of the preamble of claim 1.

### SUMMARY OF THE INVENTION

The described embodiments of the present invention provide a circuit for removing glitches caused by improper timing between received input signals. The circuit includes a transition detector having as input signals the input signals to the combinatorial circuit which is to be prevented from providing a glitch signal. When the transition detector detects a transition in one of the input signals, it provides a disable signal. The disable signal may be used to either disable the output circuit of the combinatorial circuit or disable the input circuitry of the circuit which receives the output signal of the combinatorial circuit. In one embodiment, the transition detector includes a delay generator for internally determining when to discontinue the disable signal. The delay provided by the delay generator is selected to ensure that the output signal of the combinatorial circuit is suppressed longer than the maximum anticipated timing error between the input signals to the combinatorial circuit. Because the output signal of the combinatorial circuit is suppressed until the proper input signals are provided to the combinatorial circuit, erroneous output signals caused by delay between input signals are suppressed.

In brief the invention provides a circuit for performing a combinatorial operation in response to at least two logical input signals, comprising:
a combinatorial circuit for receiving said input signals, said combinatorial circuit providing an output signal in response to said input signals; a transition detector for receiving a portion or all of said input signals, said transition detector providing a disable signal in response to a transition detected on one of said received input signals; and an output buffer for receiving said output signal, said output buffer providing a buffered output signal in response to said output signal, said output buffer being adapted to receive said disable signal and said output buffer being disabled in response to said disable signal such that a timing glitch occuring in said combinational circuit output is suppressed by said output buffer.

### BRIEF DESCRIPTION OF THE DRAWINGS

The present invention is best understood through the following Detailed Description of the preferred embodiments in conjunction with the Drawings, wherein:

Figure 1 is a schematic diagram of a prior art memory system;

Figure 2A is a schematic diagram of the column multiplexor and output buffer of Figure 1;

Figure 2B is a schematic diagram of output buffer 10 of Figure 2A;

Figure 2C is a schematic diagram of boosting circuit 20 of Figure 2B;

Figures 3A through 3E are timing diagrams of the operation of the circuit of Figure 2A;

Figure 4A is a schematic diagram of one embodiment of the present invention;

Figure 4B is a schematic diagram of transition detector 52 of Figure 4A; and

Figures 5A through 5E are timing diagrams of the operation of the circuit of Figure 4A.

## DETAILED DESCRIPTION OF THE PREFERRED EMBODIMENTS

An area where timing errors are a particular problem is in random access memories(RAMs). Timing errors are more prevalent in RAMs because of the long lead lengths which are required. This detailed description deals with an embodiment of the invention designed to prevent errors caused by line delay in providing address signals to the multiplexor which determines the column from which the output bit is selected. This type of error is very problematic in static column mode RAMs. In static column mode, column addresses are fed directly to the column multiplexor from the address input pins. Because the internal circuitry does not have control over the timing of signals coming from off the chip, extreme timing errors must be provided for in the RAM design. Although this specific embodiment is herein described, it is not to be construed as limiting the scope of the invention. Timing errors can occur with any combinatorial digital circuit such as logic gates or gate arrays, for example. In addition, although the discussion in this specification is directed toward digital circuitry, timing errors and other glitches can occur in analog circuitry as well. The invention is equally effective in preventing timing errors in these circuits as it is in the described embodiment.

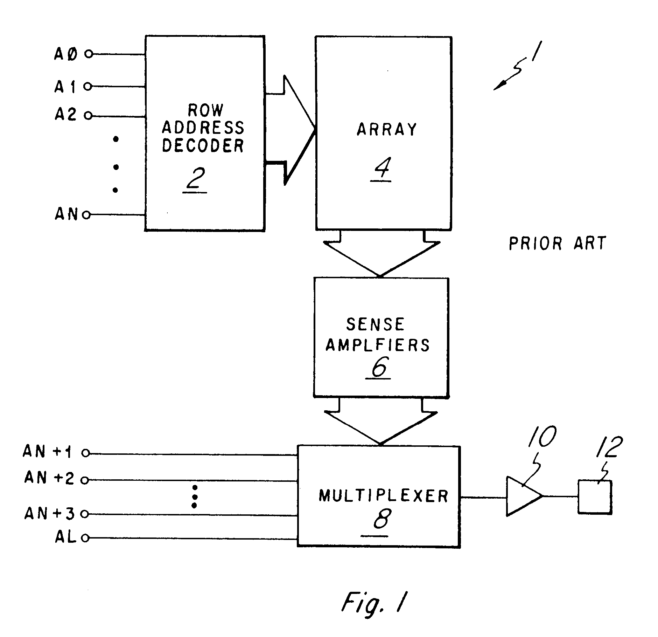

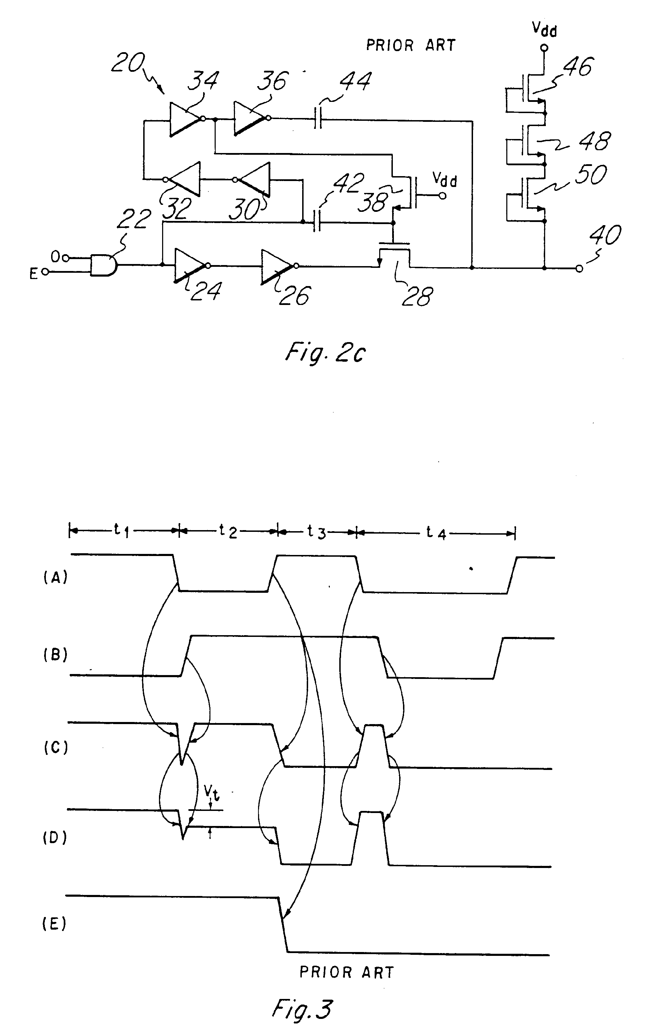

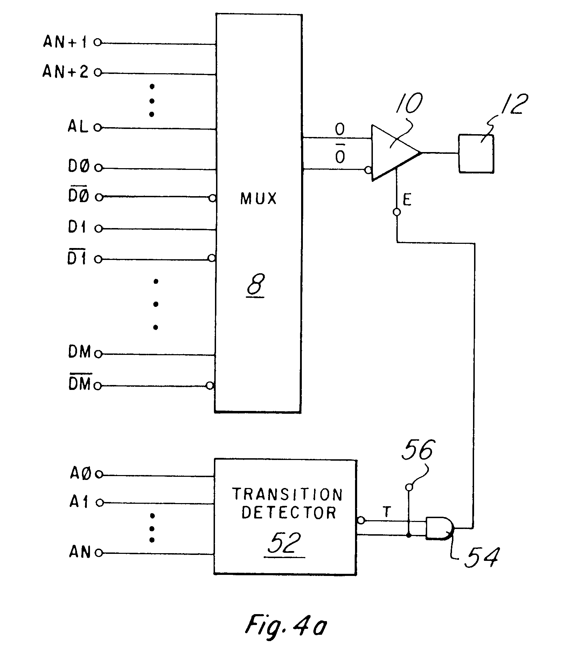

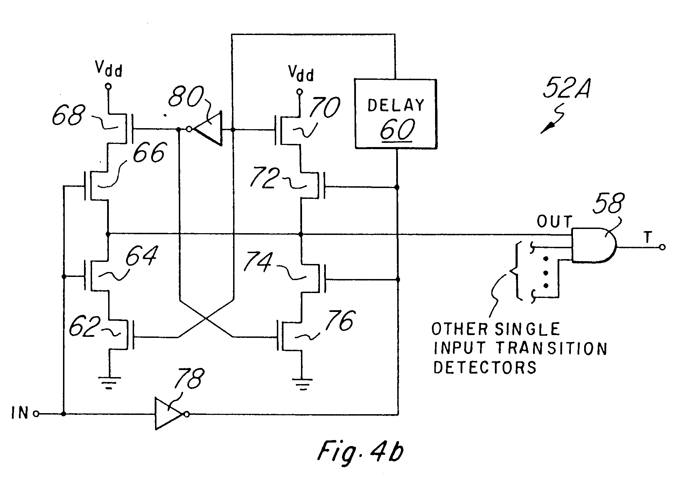

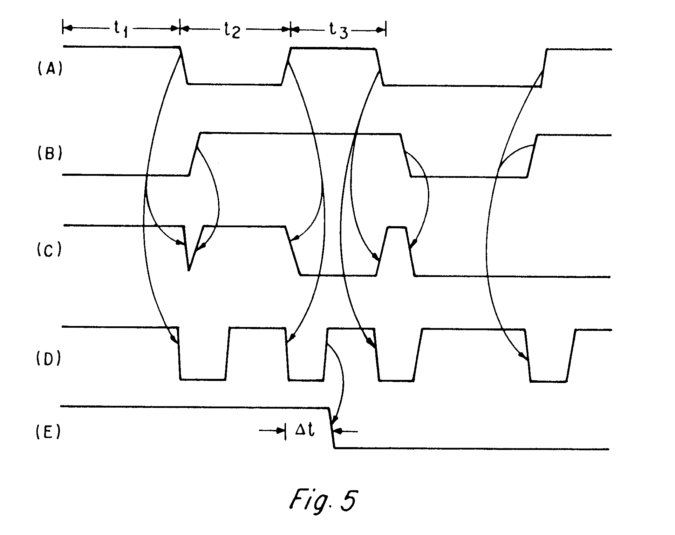

Figure 1 is a schematic diagram of a simplified prior art random access memory array. Figures 2A through 2C are schematic diagrams of the decoding multiplexor. Figures 3A through 3E constitute a timing diagram illustrating the problems created by timing errors in the prior art circuits of Figures 2A through 2C. Figures 4A and 4B are schematic diagrams illustrating one embodiment of the present invention which solves the problems illustrated in Figures 1 through 3. Figures 5A through 5E constitute a timing diagram illustrating the operation of the embodiment of Figure 4A and 4B.

Figure 1 is a schematic diagram of a prior art RAM 1. RAM 1 receives address input signals via address terminals A0 through AL. The signals provided on address terminals A0 through AN drive row address decoder 2. In response to the signals on address terminals A0 through AN, row decoder provides signals to array 4 which selects a row of memory cells in array 4. The signals in the selected memory cells are provided to sense amplifiers 6 which receive the small signals provided from the memory cells, amplify them to full logic levels (usually 0 Volts for a logical 0 and 5 Volts for a logical 1) and 'latch' or store the signals. The latched row of signals is provided to multiplexor 8. Multiplexor 8 selects one of the bits in the stored row of data in response to the address signals provided via address terminals AN+1 through AL. The selected bit is provided to output buffer 10 which provides the selected bit on output terminal 12.

In the current generation of one megabit dynamic RAMs there are 32 signals provided on address terminals AN+1 through AL selecting one of 1,024 bits of data. Because of lead layout requirements, it is almost impossible to provide equal length leads providing the address signals provided on address terminals AN+1 through AL. Thus the address signals often reach multiplexor 8 at different times, possibly generating timing errors.

Figures 2A through 2C are schematic diagrams detailing the column select circuitry of RAM 1 of Figure 1. The data bits are provided to multiplexor 8 in complementary form via terminals D0 through DM and $\overline{D0}$ through $\overline{DM}$. Multiplexor 8 selects one data bit and provides the selected data bit in complementary form on leads O and $\overline{O}$. Multiplexor 8 selects the provided data bit in response to address signals provided on address terminals AN+1 through AL. The output data bit is provided to output buffer 10 which in turn provides the data bit to output pad 12. Output buffer 10 is enabled by a signal provided on input terminal E.

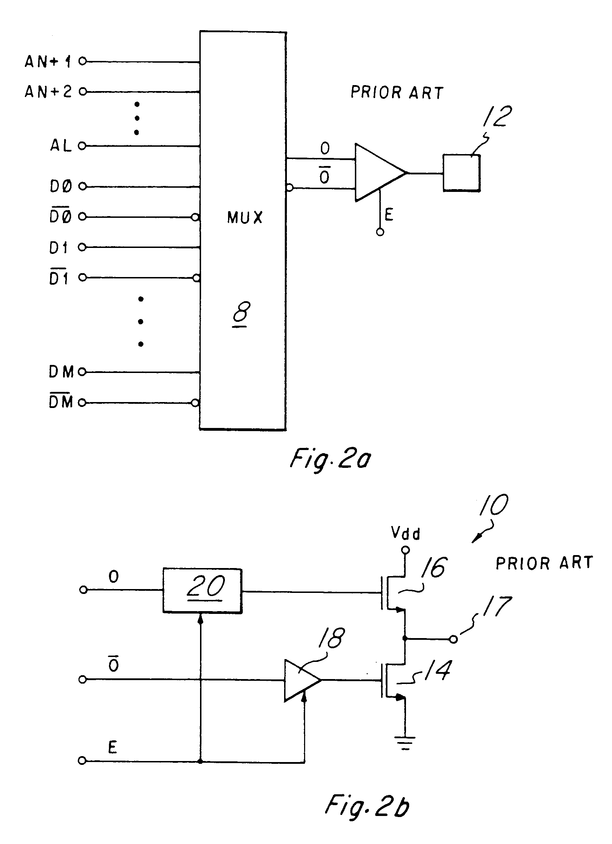

Figure 2B is a schematic diagram of output buffer 10 of Figures 1 and 2A. N-channel field effect transistors 14 and 16 drive output terminal 17. The gate of transistor 14 is driven by the signal provided on terminal $\overline{O}$ through buffer 18. For example, if a logical 0 is provided on terminal O, a complementary 1 is provided on terminal $\overline{O}$, through buffer 18 to the gate of transistor 14. Thus transistor 14 conducts and pulls down output terminal 17 to provide a logical 0 on terminal 17. When a logical 1 is provided on terminal O, a logical 0 is provided to the gate of transistor 14 through buffer 18 and thus transistor 14 does not pull down terminal 17. When a signal indicating that buffer 10 should be disabled is received on terminal E, buffer 18 provides a logical 0 signal to the gate of transistor 14 and transistor 14 does not pull down the signal on terminal 17 regardless of the signal on terminal O.

Transistor 16 is driven by booster circuit 20. N-channel transistor 16 is used instead of a P-channel transistor to avoid latch-up problems. However, when a voltage equal to a logical 1, which is approximately equal to $V_{dd}$, is provided to the gate of transistor 16, the voltage provided on terminal 17 is one threshold voltage ($V_{th}$) less than $V_{dd}$. This voltage drop is unacceptable in many applications. To eliminate this problem, boosting circuit 20 provides a signal to the gate of transistor 16 which is more than one $V_{th}$ greater than $V_{dd}$ (boosted signal). When the signal on terminal O is a logical 1, boosting circuit 20 provides a boosted signal and transistor 16 pulls up the signal on terminal 17 to $V_{dd}$. When the signal on terminal O is a logical 0, boosting circuit 20 provides a logical 0 and transistor 16 does not pull up the signal on terminal 17. When a signal indicating that buffer 10 should be disabled is received on terminal E, boosting circuit 20 provides a logical 0 output signal and transistor 16 does not pull up the signal on terminal 17 regardless of the signal on terminal O.

Figure 2C is a schematic diagram of boosting circuit 20 of Figure 2B. Many types of boosting circuits are used in the art. Figure 2C illustrates one example of a boosting circuit. When a logical 0 is provided on either terminal O or terminal E, AND gate 22 provides an output signal of 0. The output signal of AND gate 22 is inverted once by invertor 24 and inverted back by invertor 26. Thus the signal on the drain of transistor 28 is 0 volts. The output signal of AND gate 22 is also inverted once by invertor 30, inverted back by invertor 32 and inverted again by invertor 34. Thus invertor 34 provides a logical 1 or a signal of $V_{dd}$. Because the gate of transistor 38 is tied to $V_{dd}$, the drain of transistor 38, and thus the gate of transistor 28, is pulled to $V_{dd}$ less $V_{th}$. This voltage causes transistor 28 to be on which pulls terminal 40 to 0 Volts. Thus the voltage provided by boosting circuit 20 is low and transistor 16 (Figure 2B) does not conduct.

Boosting circuit 20 develops the charge to provide a boosted voltage signal during the transition from a low voltage output signal to a high voltage boosted output signal. When a logical 1 signal is provided on terminal E and the signal on terminal O changes from a logical 0 to a logical 1, the positive charge accumulated on the plate of capacitor 42 connected to the gate of transistor 28 boosts the voltage on the gate of transistor 28 to greater than $V_{dd}$. The positive charge was accumulated while the plate of capacitor 42 connected to the output terminal of AND gate 22 was held a 0 volts and the plate of capacitor 42 connected to the gate of transistor 28 was held at $V_{dd}$ less $V_{th}$. Capacitor 42 must be a relatively small capacitance device to avoid over charging of the gate of transistor 28 and thereby destroying the gate insulator of transistor 28. The internal delays of invertors 24 and 26 allow time for capacitor 42 to dump charge onto the gate of transistor 28. By the time the output signal of invertor 26 goes from logical 0 to logical 1, the gate of transistor 28 is boosted to at least $V_{dd}$ plus $V_{th}$. Therefore a full $V_{dd}$ is provided to terminal 40 through transistor 28.

The $V_{dd}$ voltage level on terminal 40 also charges the plate of capacitor 44 connected to terminal 40 with a positive charge. The plate of capacitor 40 connected to the output terminal of invertor 36 is, at this time, held to 0 Volts. While capacitor 44 is charging, the logical 1 on the input terminal of invertor 30 propagates through invertors 30, 32 and 34 to provide a logical 0 to the source of transistor 38. This logical 0 voltage level causes the gate of transistor 28 to be pulled low through transistor 38. Thus transistor 28 ceases to conduct. As this occurs, the signal on the output terminal of invertor 36 goes from a logical 0 level to a logical 1 or $V_{dd}$ level. This causes the positive charge on the plate of capacitor 44 which is connected to terminal 40 to dump charge on to terminal 40. Capacitor 44 is selected to have a very large capacitance relative to the gate capacitance of transistor 16 (Figure 2B) and the charge cannot be discharged through transistor 28, which is not conducting, so the voltage level on the gate of transistor 16 (Figure 2B) is boosted well above $V_{dd}$. Transistors 46, 48 and 50 are all gate strapped to the drain, which is connected away from $V_{dd}$, and connected in series. Therefore, these transistors will begin to conduct if the voltage on terminal 40 rises to greater than 3 times $V_{th}$ above $V_{dd}$. This limits the voltage on terminal 40 thereby avoiding damage to transistor 16 (Figure 2B).

The circuits of Figure 1 and Figures 2A through 2C are herein provided in detail to allow for a precise explanation of the problem solved by the present invention. Figures 3A through 3E are timing diagrams illustrating the problems caused by timing errors in the circuit of Figure 1 and Figures 2A through 2C. The timing diagrams of Figures 3A through 3E show the operation of a greatly simplified version of this circuit. In this example N is equal to 0 and L is equal to 2. Therefore the array 4 (Figure 1) includes 1 row and no row address signals are required. Figure 3A represents the address signal on address terminal A1 and Figure 3B represents the address signal on terminal A2. Because two binary bits can address four addresses, the row of storage elements includes 4 memory cells. The data stored in these memory cells in this example, with the corresponding addresses, are laid out in the table below.

| A1 | A2 | D |
|----|----|---|
| 0 | 0 | 0 |
| 0 | 1 | 1 |
| 1 | 0 | 1 |
| 1 | 1 | 0 |

Figure 3C shows the signal provided on terminal O (Figure 2A) by multiplexor 8 in response to the signals shown in Figures 3A and 3B and the stored data shown in the table above. During time period $t_1$, multiplexor 8 provides a logical 1 signal corresponding to the data stored in the 1-0 position (A1 = 1 and A2 = 0). During time period $t_2$, the address signals provided indicate that the data stored at position 0-1 is to be provided and thus a logical 1 is placed on terminal O. However, due to timing errors multiplexor 8 temporarily provides the data stored at position 0-0. This shows up as a downward spike in the signal provided on terminal O.

In most circumstances, the spike on terminal O is ignored by subsequent circuitry because the circuitry is designed to ignore such spikes. However, the circuit of Figure 2C is affected adversely by this type of spike. Figure 3D is a timing diagram of the signal provided on terminal 17 (Figure 2B). During time period $t_1$, output buffer 10 provides a full $V_{dd}$ output signal on terminal 17 because boosting circuit 20 boosts the voltage on the gate of transistor 16 (Figure 2B) well above $V_{dd}$ plus $V_{th}$. When boosting circuit 20 receives the spike, the 'temporary' logical 0 propagates through boosting circuit 20 to provide a logical 0 on the output terminal of invertor 26. The logical 0 also propagates through to cause a logical 1 on the output terminal of invertor 34. This logical 1 turns on transistor 28 through transistor 38. This begins to pull the voltage level on terminal 40 to 0. When the proper signal is provided to boosting circuit 20. Capacitor 44 is unable to charge sufficiently to provide proper boosting to the gate of transistor 16 (Figure 2B). Thus an inadequate voltage of $V_{dd}$ less $V_{th}$ is provided on output terminal 17. In some situations this inadequate voltage can cause major data errors and is thus unacceptable.

An upward spike is illustrated by the transition from time period $t_3$ to time period $t_4$. An upward spike does not cause output errors in this particular circuit, but can cause errors in some circuits. Figure 3E is a timing diagram showing the desired output signal on terminal 17.

In certain applications it is necessary to eliminate spikes generated by timing errors. Figures 4A and 4B are schematic diagrams of one embodiment of the present invention designed to alleviate the spikes illustrated above in conjunction with Figures 1, 2A through 2C and Figures 3A through 3E. The embodiment of Figures 4A and 4B illustrate the example of the present invention with regard to column demultiplexion of data stored in a random access memory device. Although this one embodiment is described herein, the specific embodiment is not to be construed in any way as limiting the scope of the invention. The present invention finds broad applicability in any combinatorial logic or other type of circuit accepting two or more input signals and providing an output signal in response thereto.

Figure 4A is a schematic diagram of one embodiment of the present invention. Multiplexor 8, buffer 10 and output terminal 12 operate in the same manner as similarly numbered components in Figure 2A. The circuit of Figure 4A further includes transition detector 52. Enable signals are often provided externally to the chip or generated on chip in response to other signals. In this embodiment, this signal is provided to the circuit of Figure 4A via terminal 56. The address signals provided on address terminals An+1 through AL are provided to transition detector 52. Transition detector 52 provides an output signal on terminal T which is a logical 1 when no transition has been detected and a logical 0 when a transition is detected. When a logical 1 is provided by transition detector 52 and a logical 1 enable signal is provided on terminal 56, AND gate 54 provides a logical 1 to output buffer 10 and output buffer 10 provides an output signal to terminal 12 dependent on the signal provided on terminals O and $\overline{O}$. If the enable signal on terminal 56 or the output signal of transition detector 52 is logical 0, output buffer 10 is disabled an provides a high impedance to terminal 12.

A schematic diagram of a portion of transition detector 52 is shown in Figure 4B. The portion shown in Figure 4B operates on one input signal provided on terminal IN. If multiple input signals are to processed by transition detector 52, one of each of the circuits shown in Figure 4B must be provided and the output signals of the multiple circuits, provided on terminal OUT, must be combined by a AND gate such as AND gate 58. Single input transition detector 52A operates by providing a temporary transition detect signal of logical 0, in response to a detected transition, on terminal OUT of a duration set by delay unit 60.

In discussing the operation of partial transition detector 52A, transistors 62, 64, 66, 68, 70, 72, 74 and 76 are assumed to be pure switching devices. Therefore, when one of these transistors is said to 'on' it means the transistor channel is conducting. Conversely, when a transistor is said to be 'off' it means the transistor channel is not conducting. When a logical 0 signal is provided on terminal IN, P-channel transistor 66 is on and N-channel transistor 64 is off. The signal on IN is inverted by invertor 78 and the output signal of logical 1 causes P-channel transistor 72 to be off and N-channel transistor 74 to be on. Assuming the signal on IN has been a logical 0 longer than the fixed delay of delay circuit 60, a logical 1 signal is provided to the gate of P-channel transistor 70 and the gate of N-channel transistor 62. Thus transistor 70 is off and transistor 62 is on. The logical 1 provided to the input terminal of invertor 80 is inverted to provide a logical 0 on the gates of P-channel transistor 68 and N-channel transistor 76. Thus transistor 68 is on and transistor 76 is off. In this state, the only path from terminal OUT to either $V_{dd}$ or ground is through transistors 66 and 68. Therefore, the signal provided on terminal OUT is $V_{dd}$ or a logical 1.

When the signal on terminal IN changes to a logical 1, P-channel transistor 66 turns off and N-channel transistor 64 turns on. At this time, the change in the signal has not propagated through delay unit 60 so a logical 1 is on the gate of N-channel transistor 62 and transistor 62 is on. Because both transistors 62 and 64 are on and transistor 66 is off, the signal on terminal OUT is pulled to ground or a logical 0. The logical 1 on terminal IN is inverted by invertor 78 to provide a logical 0 on the gates of P-channel transistor 72 and N-channel transistor 74. Thus transistor 72 is turned on and transistor 74 is turned off. Because the new signal has not yet propagated through delay unit 60, the signal on the gate of P-channel transistor 70 is a logical 1 and transistor 70 is off. After the logical 0 has propagated through delay unit 60, the logical 0 on the gates of P-channel transistor 70 and N-channel transistor 62 causes transistor 70 to turn on and transistor 62 to turn off. Therefore, the path from terminal OUT to ground is broken and a path from terminal out through transistors 70 and 72 to $V_{dd}$ is established providing a logical 1 signal on terminal OUT. Thus partial transition detector 52A provides a logical 0 output signal after the transition from logical 0 to logical 1 of the signal on terminal IN for a period determined by the delay built into delay unit 60. The delay of delay unit 60 may be provided by any number of techniques, such as RC timing delays, multiple gate delays or clocked timing, for example. The logical 0 output signal of delay unit 60 is inverted by invertor 80 to provide a logical 1 on the gates of P-channel transistor 68 and N-channel transistor 76. Thus transistor 68 is off and transistor 76 is on.

If the signal on terminal IN now changes from a logical 1 to a logical 0, invertor 78 inverts the signal on terminal IN to provide a logical 1 on the gates of P-channel transistor 72 and N-channel transistor 74. Thus transistor 72 turns off and transistor 74 turns on. Transistor 76 remains on until this logical 1 has propagated through delay unit 60 and invertor 80. Therefore, the path from terminal OUT to $V_{dd}$ is broken at transistor 72 and a path from terminal OUT through transistors 74 and 76 to ground is established. Thus a logical 0 output signal is provided on terminal OUT. The logical 0 on terminal IN causes P-channel transistor 66 to turn on and N-channel transistor 64 to turn off. After the logical 1 signal provided by invertor 78 has propagated through delay unit 60, invertor 80 inverts this signal to provide a logical 0 on the gates of P-channel transistor 68 and N-channel transistor 76. Thus transistor 68 turns on and transistor 76 turns off. Therefore, the path from terminal OUT to ground is broken at transistor 76 and a path from terminal OUT through transistors 66 and 68 is established. Thus a logical 1 is provided on terminal OUT. The logical 1 provided by delay unit 60 causes P-channel transistor 70 to turn off and N-channel transistor 62 to turn on. This brings partial transition detector 52A to the quiescent state with a logical 0 input signal as described above. In summary, partial transition detector 52A provides a logical 0 output signal of selected duration upon the transition of the signal provided on terminal IN from either a logical 0 to a logical 1 or from a logical 1 to a logical 0. Otherwise, partial transition detector provides a logical 1 output signal.

The output signals of the partial transition detectors (only partial transition detector 52A is shown) are provided as input signals to AND gate 58. When no transitions are detected by the partial transition detectors, all the input signals to AND gate 58 are logical 1 and the output signal of AND gate 58 is a logical 1. If any of the partial transition detectors detects a transition, one of the input signals to AND gate 58 is a logical 0 and the output signal of AND gate 58 is a logical 0.

The operation of the embodiment of Figures 4A and 4B is illustrated in the timing diagrams of Figures 5A through 5E. Figures 5A through 5C are the same a Figures 3A through 3C and describe the same signals. The signals shown in Figures 5A and 5B are provided to transition detector 52 and the output of transition detector 52 is shown in Figure 5D. When a transition is detected, transition detector 52 provides a logical 0 signal to AND gate 54 which then provides a logical 0 to enable terminal E of buffer 10. The logical 0 enable signal causes boosting circuit 20 (Figure 2C) to provide a logical on terminal 40 (Figure 2C). This causes capacitor 44 (Figure 2C) to discharge. However, the delay provided by transition detector 52 is selected to be long enough to allow capacitor 44 to charge and thus allow boosting circuit 20 to operate normally. Thus when spikes occur at the transitions from time periods $t_1$ to $t_2$ and $t_3$ to $t_4$ as shown in Figure 5C, output buffer 10 is disabled and the output signal of output buffer 10 is suppressed. Although output buffer 10 is providing a high impedance output signal, the time periods involved are so short that the signal on terminal 12 does not change while the output signal of buffer 12 is suppressed. This is reflected in Figure 5E. Thus output buffer 10 provides the spikeless output signal shown in Figure 5E on output terminal 12, By blocking the downward spike, the present embodiment allows boosting circuit 20 to properly charge, thus providing a full $V_{dd}$ output signal during time period $t_2$ unlike the prior art signal shown in Figure 3D. As alternative embodiments, the disable signal may be provided directly to the combinatorial circuit or to circuitry interposed between multiplexor 8 and output buffer 10. Any of these embodiments are design choices which are clearly within the scope of the present invention.

Although specific embodiments are herein described, it is not to be construed as limiting the scope of the invention. The scope of the invention is only limited by the claims appended hereto in which we claim:

**Claims**

1.  A circuit for performing a combinatorial operation
    in response to at least two logical input signals,
    comprising:
    a combinatorial circuit (2, 4, 6, 8) for receiving
    said input signals, said combinatorial circuit (2, 4,
    6, 8) providing an output signal in response to
    said input signals; a transition detector (52) for receiving a portion or all of said input signals, said
    transition detector (52) providing a disable signal
    in response to a transition detected on one of said
    received input signals; and an output buffer (10)
    for receiving said output signal, said output buffer
    (10) providing a buffered output signal in response to said output signal, said output buffer
    (10) being adapted to receive said disable signal
    and said output buffer (10) being disabled in response to said disable signal Characterized in
    that said combinatorial circuit remains functional
    and that a timing glitch occuring in a combinator-
    ial circuit output (0, $\overline{0}$) is suppressed by said output buffer (10).

2.  A circuit as claimed in claim 1 wherein said output
    buffer (10) includes transistors (14, 16) between
    power leads providing said buffered output.

3.  A circuit as claimed in claim 2 and wherein said
    transistors (14, 16) are n-channel devices.

4.  A circuit as claimed in claim 2 or claim 3 and
    wherein said transistors provide pull up or pull
    down to an output line (17).

5.  A circuit as claimed in claim 2, claim 3 or claim 4
    and including a boost circuit (20) connected to at
    least one of said output transistors (14, 16), said
    boost circuit (20) including a charging circuit for
    accumulating charge for a certain period to boost
    said at least one output transistor to a desired output voltage.

6.  A circuit as claimed in claim 5 wherein said charging circuit includes a capacitor (42) accumulating
    said charge.

7.  A circuit as claimed in claim 5 or claim 6 and
    wherein said charging circuit accumulates charge
    for a certain period sufficient to boost said at least
    one output transistor (14, 16) to conduct at least
    the voltage of said power leads.

8.  A circuit of any of claims 2 to 7 wherein said transition detector (52) includes one set of transistors (64, 66) connected to receive one of said input
signals, another set of transistors (72, 74) connected between said power leads and said one
set of transistors (64, 66) and a delay circuit (60)
arranged to connect said other set of transistors
(72, 74) to said one set of transistors to delay operation of said one set of transistors (64, 66).

9.  A circuit as claimed in claim 5 or any of claims 6
    to 8 in that they depend from claim 5 and including logic circuitry (30, 32, 34, 36) for discharging
    the accumulated charge each time there is an input transition.

10. A circuit as claimed in any preceding claim and
    wherein said disable signal is provided as a first
    input (T) to a gate (54), said gate having a second
    input (56) for receiving a second disabled signal.

11. A circuit as claimed in any preceding claim and
    wherein said combinatorial circuit is decode circuitry for a memory device.

**Patentansprüche**

1.  Schaltung zum Durchführen einer kombinatorischen Operation als Reaktion auf wenigstens
    zwei logische Eingangssignale, enthaltend:
    eine kombinatorische Schaltung (2, 4, 6, 8) zum
    Empfang der Eingangssignale, wobei die kombinatorische Schaltung (2, 4, 6, 8) ein Ausgangssignal als Reaktion auf die Eingangssignale erzeugt;
    einen Übergangsdetektor (52) zum Empfang eines Teils oder aller Eingangssignale, wobei der
    Übergangsdetektor (52) als Reaktion auf einen
    erfaßten Übergang bei einem der empfangenen
    Eingangssignale ein Sperrsignal erzeugt; und
    einen Ausgangspuffer (10) zum Empfang des
    Ausgangssignals, wobei der Ausgangspuffer
    (10) als Reaktion auf das Ausgangssignal ein
    gepuffertes Ausgangssignal abgibt und der Ausgangspuffer (10) an den Empfang des Sperrsignals angepaßt ist und der Ausgangspuffer (10)
    als Reaktion auf das Sperrsignal gesperrt wird,
    dadurch gekennzeichnet,
    daß die kombinatorische Schaltung funktionsfähig bleibt und
    daß ein am Ausgang (0, $\overline{0}$) einer kombinatiori-
    schen Schaltung auftretender laufzeitbedingter
    Störimpuls durch den Ausgangspuffer (10) unterdrückt wird.

2.  Schaltung gemäß Anspruch 1, in der der Aus-
    gangspuffer (10) zwischen den Versorgungslei-
    tungen Transistoren (14, 16) enthält, die das
    gepufferte Ausgangssignal abgeben.

3. Schaltung gemäß Anspruch 2, in der die Transistoren (14, 16) n-Kanal-Vorrichtungen sind.

4. Schaltung gemäß Anspruch 2 oder Anspruch 3, in der die Transistoren zum Ziehen der Ausgangsleitung (17) auf H- oder L-Pegel dienen.

5. Schaltung gemäß Anspruch 2, Anspruch 3 oder Anspruch 4, enthaltend eine Booster-Schaltung (20), die mit wenigstens einem der Ausgangstransistoren (14, 16) verbunden ist, wobei die Booster-Schaltung (20) eine Ladungsschaltung zum Akkumulieren von Ladung über einen gewissen Zeitraum hinweg zum Anheben wenigstens eines Ausgangstransistor auf eine gewünschte Ausgangsspannung enthält.

6. Schaltung gemäß Anspruch 5, in der die Ladungsschaltung eine Kapazität (42) enthält, in der die Ladung akkumuliert wird.

7. Schaltung gemäß Anspruch 5 oder Anspruch 6, bei der die Ladungsschaltung die Ladung über einen gewissen Zeitraum hinweg akkumuliert, der ausreicht, um den wenigstens einen Ausgangstransistor (14, 16) so anzuheben, daß er wenigstens die Spannung der Versorgungsleitungen führt.

8. Schaltung nach einem der Ansprüche 2 bis 7, in der der Übergangsdetektor (52) eine Gruppe von Transistoren (64, 66) enthält, die so verbunden sind, daß sie eines der Eingangssignale empfangen, wobei eine andere Gruppe von Transistoren (72, 74), die zwischen den Versorgungsleitungen und der einen Gruppe von Transistoren (64, 66) und einer Verzögerungsschaltung (60) angeschlossen ist, die so angeordnet ist, daß sie die andere Gruppe von Transistoren (72, 74) mit der einen Gruppe von Transistoren zum Verzögern des Betriebs der einen Gruppe von Transistoren (64, 66) verbindet.

9. Schaltung gemäß dem Anspruch 5 oder einem der Ansprüche 6 bis 8, soweit sie von Anspruch 5 abhängen, mit Logikschaltungen (30, 32, 34, 36) zum Entladen der akkumulierten Ladung immer dann, wenn ein Eingangsübergang auftritt.

10. Schaltung nach einem der vorstehenden Ansprüche, bei der das Sperrsignal einem ersten Eingang (T) eines Gatters (54) zugeführt wird, wobei das Gatter einen zweiten Eingang (56) zum Empfang eines zweiten gesperrten Signals enthält.

11. Schaltung gemäß einem der vorstehenden Ansprüche, in der die kombinatorische Schaltung die Dekodierschaltung einer Speichervorrichtung darstellt.

**Revendications**

1. Circuit pour réaliser une opération combinatoire en réponse à au moins deux signaux d'entrée logiques, comprenant:
   - un circuit combinatoire (2, 4, 6, 8) pour recevoir lesdits signaux d'entrée, ledit circuit combinatoire (2, 4, 6, 8) fournissant un signal de sortie en réponse auxdits signaux d'entrée;
   - un détecteur de transition (52) pour recevoir une partie ou la totalité desdits signaux d'entrée, ledit détecteur de transition (52) fournissant un signal d'invalidation en réponse à une transition détectée sur l'un desdits signaux d'entrée reçus; et
   - un circuit de tampon de sortie (10) pour recevoir ledit signal de sortie, le circuit de tampon de sortie (10) fournissant un signal de sortie du circuit de tampon en réponse audit signal de sortie, ledit circuit de tampon de sortie (10) étant adapté pour recevoir ledit signal d'invalidation et ledit circuit de tampon de sortie (10) étant invalidé en réponse audit signal d'invalidation, caractérisé en ce que ledit circuit combinatoire reste fonctionnel et en ce qu'une variation brusque de retard se produisant dans une sortie du circuit combinatoire $(0,\overline{0})$ est supprimée par ledit circuit de tampon de sortie (10).

2. Circuit selon la revendication 1 dans lequel ledit circuit de tampon de sortie (10) comporte des transistors (14, 16) entre des conducteurs de courant fournissant ladite sortie du circuit de tampon.

3. Circuit selon la revendication 2 dans lequel lesdits transistors (14, 16) sont des dispositifs à canal -n.

4. Circuit selon l'une des revendications 2 et 3 dans lequel lesdits transistors fournissent une ligne de sortie (17) d'excursion haute ou basse.

5. Circuit selon l'une quelconque des revendications 1, 3 et 4 comportant un circuit d'augmentation de de tension (20) relié à au moins un desdits transistors de sortie (14, 16), ledit circuit d'augmentation de tension (20) comportant un circuit de charge pour accumuler une charge pendant une certaine durée pour augmenter la tension dudit au moins un transistor de sortie jusqu'à une tension de sortie désirée.

6. Circuit selon la revendication 5 dans lequel ledit circuit de charge comporte un condensateur (42) pour accumuler ladite charge.

7. Circuit selon l'une des revendications 5 et 6 dans lequel ledit circuit de charge accumule la charge pendant une certaine durée suffisante pour augmenter la tension dudit au moins un transistor de sortie (14, 16) pour conduire au moins la tension audit conducteur de courant.

8. Circuit selon l'une quelconque des revendications 2 à 7 dans lequel ledit détecteur de transition (52) comporte un premier ensemble de transistors (64, 66) relié pour recevoir un desdits signaux d'entrée, un second ensemble de transistors (72, 74) relié entre lesdits conducteurs de courant et ledit premier ensemble de transistors (64, 66) et un circuit de retard (60) adapté pour relier ledit second ensemble de transistors (72, 74) audit premier ensemble de transistors pour retarder le fonctionnement dudit premier ensemble de transistors (64, 66).

9. Circuit selon la revendication 5 ou selon l'une quelconque des revendications 6 à 8 dépendantes de la revendication 5 comportant un circuit logique (30, 32, 34, 36) pour décharger la charge accumulée chaque fois que se produit une transition d'entrée.

10. Circuit selon l'une quelconque des revendications précédentes dans lequel ledit signal d'invalidation est disponible en tant que première entrée (T) à une porte (54), ladite porte comportant une seconde entrée (56) pour recevoir un second signal d'invalidation.

11. Circuit selon l'une quelconque des revendications précédentes dans lequel ledit circuit combinatoire est un circuit de décodage pour un dispositif à mémoire.

A∅ o——

A 1 o——

A2 o——
•
•
•

AN o——

ROW
ADDRESS
DECODER
2

ARRAY
4

PRIOR ART

SENSE
AMPLFIERS
6

AN +1 o——

AN +2 o——
•
•
•

AN +3 o——

AL o——

MULTIPLEXER
8

10

12

Fig. 1

Fig. 2a

Fig. 2b

11

PRIOR ART

Fig. 2c

Fig. 3

PRIOR ART

Fig. 4a

Fig. 4b

EP 0 361 233 B1

Fig. 5